# EUROPEAN PATENT APPLICATION

(11) **EP 4 770 360 A1**
(43) Date of publication of application: **01.07.2026**
(21) Application number: 25224523.8
(22) Date of filing: 17.12.2025
(51) Int. Cl.: H10K 10/00, H10K 59/121, H10K 59/122, H10K 59/124, H10K 59/80, H10K 59/123

(54) **LIGHT EMITTING DIODE DISPLAY DEVICE**

(30) Priority: 30.12.2024 KR 20240200246
(71) Applicant: LG Display Co., Ltd., Seoul, 07336 (KR)
(72) Inventor: HA, Jong-Moo, 10845 Paju-si, Gyeonggi-do (KR)
(74) Representative: Ter Meer Steinmeister & Partner

(57) **Abstract**

A light emitting diode display device comprises a substrate including a plurality of emission areas and a non-emission area between the emission areas; a planarization layer corresponding to the emission areas and the non-emission area and disposed on the substrate; a plurality of domes corresponding to the emission areas and disposed on the planarization layer, the plurality of domes spaced apart from each other; a partition wall corresponding to the non-emission area and disposed on the planarization layer, the partition wall spaced apart from the domes; a first electrode covering the planarization layer in the emission area, the domes and at least a portion of the partition wall; and a bank disposed in the non-emission area and covering the bank.

## Description

The application claims priority of Korean Patent Application No. 10-2024-0200246 filed in the Republic of Korea on December 30, 2024.

### FIELD OF TECHNOLOGY

The disclosure relates to a light emitting diode display device, and more specifically, to a light emitting diode display device being capable of having improved emitting efficiency and preventing a color mixture.

### BACKGROUND

Recently, requirement for flat panel display devices having small occupied area is increased. Among the flat panel display devices, a technology of a light emitting diode display device including a light emitting diode is rapidly developed.

The light emitting diode display device may be classified into an organic light emitting diode (OLED) display device and an inorganic light emitting diode display device.

For example, in the OLED display device, holes from an anode and electrons from a cathode are combined to generate an exciton in an organic light emitting layer, and the exciton is transformed from an excited state to a ground state. As a result, the light is emitted from the OLED.

### SUMMARY

The disclosure is directed to a light emitting diode display device that substantially obviates one or more of the problems associated with the limitations and disadvantages of the related conventional art.

An object is to provide a light emitting diode display device being capable of having improved emitting efficiency and preventing a color mixture.

An object is to provide a light emitting diode display device being capable of efficiently controlling a viewing angle.

Additional features and advantages of the disclosure are set forth in the description which follows, and will be apparent from the description, or evident by practice of the present disclosure. The objectives and other advantages of the disclosure are realized and attained by the features described herein as well as in the appended drawings.

The object is solved by the features of the independent claims. Preferred embodiments are given in the dependent claims.

To achieve these and other advantages in accordance with the purpose of the embodiments of the disclosure, as described herein, an aspect of the disclosure is a light emitting diode display device comprising a substrate including a plurality of emission areas and a non-emission area between the emission areas; a planarization layer corresponding to the emission areas and the non-emission area and disposed on the substrate; a plurality of domes corresponding to the emission areas and disposed on the planarization layer, the plurality of domes spaced apart from each other; a partition wall corresponding to the non-emission area and disposed on the planarization layer, the partition wall spaced apart from the domes; a first electrode covering the planarization layer in the emission area, the domes and at least a portion of the partition wall; and a bank disposed in the non-emission area and covering the first electrode and/or the partition wall.

In the following optional features are provided which might be combined with the general idea of the invention alone, in combination or in sub-combination.

In one or more embodiments, each of the domes may have a first thickness.

In one or more embodiments, the partition wall may have a second thickness.

In one or more embodiments, the second thickness may be same as the first thickness.

In one or more embodiments, the second thickness may be larger than the first thickness.

In one or more embodiments, the domes may include a first dome and a second dome positioned between the first dome and the partition wall.

In one or more embodiments, the first dome may have a first thickness, and the partition wall may have a second thickness.

In one or more embodiments, the second dome may have a third thickness larger than the first thickness and smaller than the second thickness.

In one or more embodiments, the partition wall may have a reverse-tapered shape.

In one or more embodiments, the first electrode may cover a side surface of the partition wall.

In one or more embodiments, the first electrode may expose an upper surface of the partition wall.

In one or more embodiments, the planarization layer may have a third thickness in the emission area and a fourth thickness in the non-emission area.

In one or more embodiments, the fourth thickness may be larger than the third thickness.

In one or more embodiments, the dome may have a first thickness, and the partition wall may have a second thickness, wherein the second thickness may be same as the first thickness.

In one or more embodiments, the dome may have a first thickness, and the partition wall may have a second thickness, wherein the second thickness may be smaller than the first thickness.

In one or more embodiments, the planarization layer positioned between the dome in an edge of the emission area and the partition wall may include a first groove.

In one or more embodiments, the planarization layer may further include a second groove corresponding to a space between adjacent domes.

In one or more embodiments, the first groove may have a first depth, and the second groove may have a second depth, wherein the second depth may be smaller than the first depth.

In one or more embodiments, the planarization layer may be a flat surface corresponding to a space between adjacent domes.

In one or more embodiments, a thickness of the partition wall may be same as a thickness of the dome.

In one or more embodiments, adjacent two of the domes may be spaced apart from each other by a first distance.

In one or more embodiments, the partition wall may be spaced apart from the dome by a second distance.

In one or more embodiments, the second distance may be smaller than the first distance.

In one or more embodiments, the light emitting diode display device may further comprise a light emitting layer on the first electrode; and a second electrode on the light emitting layer.

In one or more embodiments, the substrate may include a first pixel, a second pixel and a third pixel, and each of the first to third pixels may include the emission area.

In one or more embodiments, the first pixel may extend along a first direction, a second pixel may be spaced apart from the first pixel in a second direction, and a third pixel may be disposed at one side of the first and second pixels in the first direction.

In one or more embodiments, the light emitting diode display device may further comprise a thin film transistor in each of the first to third pixels.

In one or more embodiments, a first contact hole for electrically connecting the first electrode in the first pixel to the thin film transistor in the first pixel may be positioned at a side of the first pixel toward the second pixel.

In one or more embodiments, a second contact hole for electrically connecting the first electrode in the second pixel to the thin film transistor in the second pixel may be positioned at a side of the second pixel toward the first pixel.

In one or more embodiments, a third contact hole for electrically connecting the first electrode in the third pixel to the thin film transistor in the third pixel may be positioned at a side of the third pixel toward the first and second pixels.

It is to be understood that both the foregoing general description and the following detailed description are exemplary and explanatory and are intended to further explain the present disclosure as claimed.

### BRIEF DESCRIPTION OF THE DRAWINGS

The accompanying drawings, which are included to provide a further understanding of the present disclosure and are incorporated in and constitute a part of this specification, illustrate embodiments of the disclosure and together with the description serve to explain the principles of the disclosure.
FIG. 1 is a schematic view illustrating a light emitting diode display device of the disclosure.
FIG. 2 is a schematic cross-sectional view illustrating a light emitting diode display device of the disclosure.
FIG. 3 is a schematic cross-sectional view illustrating one unit pixel of a light emitting diode display device of the disclosure.
FIG. 4 is a schematic cross-sectional view illustrating a light emitting diode display device of a first embodiment of the disclosure.
FIG. 5 is a schematic cross-sectional view illustrating a light emitting diode display device of a second embodiment of the disclosure.
FIG. 6 is a schematic cross-sectional view illustrating a light emitting diode display device of a third embodiment of the disclosure.
FIG. 7 is a schematic an organic light emitting view illustrating a light emitting diode of a fourth embodiment of the disclosure.
FIG. 8 is a schematic an organic light emitting view illustrating a light emitting diode of a fifth embodiment of the disclosure.
FIG. 9 is a schematic an organic light emitting view illustrating a light emitting diode of a sixth embodiment of the disclosure.

### DETAILED DESCRIPTION

Reference will now be made in detail to aspects of the disclosure, examples of which may be illustrated in the accompanying drawings. In the following description, when a detailed description of well-known functions or configurations related to this document is determined to unnecessarily cloud a gist of the inventive concept, the detailed description thereof will be omitted. The progression of processing steps and/or operations described is an example; however, the sequence of steps and/or operations is not limited to that set forth herein and may be changed as is known in the art, with the exception of steps and/or operations necessarily occurring in a particular order. Like reference numerals designate like elements throughout. Names of the respective elements used in the following explanations are selected only for convenience of writing the specification and may be thus different from those used in actual products.

Advantages and features of the disclosure and methods of achieving them will be apparent with reference to the aspects described below in detail with the accompanying drawings. However, the disclosure is not limited to the aspects disclosed below, but can be realized in a variety of different forms, and only these aspects allow the disclosure of the disclosure to be complete. The disclosure is provided to fully inform the scope of the disclosure to the skilled in the art of the disclosure.

The shapes, sizes, proportions, angles, numbers, and the like disclosed in the drawings for explaining the aspects of the disclosure are illustrative, and the disclosure is not limited to the illustrated matters. The same reference numerals refer to the same elements throughout the specification. In describing the disclosure, if it is determined that a detailed description of the related known technology unnecessarily obscure the subject matter of the disclosure, the detailed description thereof can be omitted. When 'including', 'having', 'consisting', and the like are used in this specification, other parts may be added unless 'only' is used. When a component is expressed in the singular, cases including the plural are included unless specific statement is described.

The expression "at least one of a, b, and c" described throughout the specification can encompass 'a alone', 'b alone', 'c alone', 'a and b', 'a and c', 'b and c', or 'all of a, b, and c'. The advantages and features of the present invention, and the methods for achieving them, will become apparent by referring to the embodiments described in detail below together with the accompanying drawings.

In construing an element, the element is construed as including an error or tolerance range although there is no explicit description of such an error or tolerance range.

In describing a position relationship, for example, when a position relation between two parts is described as, for example, "on," "over," "under," and "next," one or more other parts may be disposed between the two parts unless a more limiting term, such as "just" or "direct(ly)" is used.

In describing a time relationship, for example, when the temporal order is described as, for example, "after," "subsequent," "next," and "before," a case that is not continuous may be included unless a more limiting term, such as "just," "immediate(ly)," or "direct(ly)" is used.

The area, length, or thickness of each component described in the specification is illustrated for convenience of explanation, and the invention is not necessarily limited to the area and thickness of the illustrated component.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the disclosure.

Features of various aspects of the disclosure may be partially or overall coupled to or combined with each other, and may be variously inter-operated with each other and driven technically as those skilled in the art can sufficiently understand. The aspects of the disclosure may be carried out independently from each other, or may be carried out together in co-dependent relationship.

Without specific description, a transistor constituting the pixel circuit of the present disclosure may include at least one of an oxide thin film transistor (Oxide TFT), an amorphous silicon TFT (a-Si TFT), and a low temperature poly silicon (LTPS) TFT.

The following embodiments are described with reference to a light emitting diode display device. However, the embodiment of the disclosure is not limited to an organic light emitting diode display device. For example, a light emitting diode display device according to an embodiment of the present disclosure may be an organic light emitting diode display device using an organic light emitting material or an inorganic light emitting diode display device using an inorganic light emitting material such as a quantum dot.

Reference will now be made in detail to some of the examples and preferred embodiments, which are illustrated in the accompanying drawings.

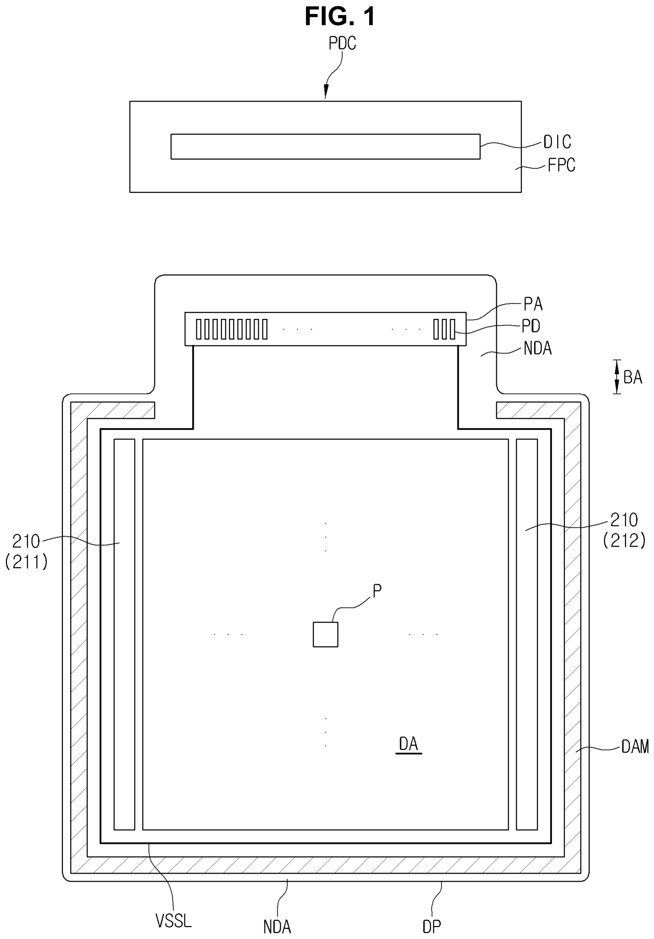

FIG. 1 is a schematic view illustrating a light emitting diode display device of the disclosure.

Referring to FIG. 1, a light emitting diode display device of the disclosure may include a display panel DP and a driving circuit unit for driving the display panel DP.

For example, the driving circuit unit may include a gate driver (e.g., a gate driving circuit) 210 and a panel driving circuit PDC. The driving circuit unit may further include a timing controller (e.g., a timing control circuit) and a power supply (e.g., a power circuit) for supplying a power for driving the light emitting diode display device.

The display panel DP may include a display area DA displaying an image and a non-display area NDA outside or surrounding the display area DA.

In the display area DA, a plurality of pixels (e.g., a pixel region) P may be arranged along a plurality of horizontal lines (e.g., a raw line) and a plurality of vertical lines (e.g., a column line). Namely, the pixels may be arranged in a matrix shape.

For example, the pixels may include red, green and blue pixels for displaying red, green and blue, respectively, but it is not limited thereto.

Various signal lines providing driving voltages to the pixels may be formed on a substrate of the display panel DP.

For example, a data line for providing a data signal (e.g., a data voltage) as an image signal extends along a vertical direction to be connected to the pixels P in the vertical line.

A gate line for providing a gate signal (e.g., a gate voltage) extends along a horizontal direction to be connected to the pixels P in the horizontal line.

The gate line and the data line cross each other to define the pixel P.

Each pixel P may include a light emitting diode as a light emitting element. Each pixel P may further include a plurality of transistors and at least one capacitor for driving the light emitting diode.

A data driver receives an image data and a data control signal from the timing controller, and in response to the data control signal, converts the image data into a data voltage, which is analog image data, and outputs the data voltage to the corresponding data line.

For example, the power supply generates the DC power required to drive the pixel array and driving circuit of the display panel DP using a DC-DC converter. The DC-DC converter may include a charge pump, a regulator, a buck converter, a boost converter, and so on.

The gate driver 210 receives a gate control signal from the timing controller, generates a gate signal, and sequentially applies the gate signal to the gate line. For example, the gate signals may be sequentially output in a vertical direction from top to bottom.

The gate driver 210 may be arranged, for example, on at least one side of the display area DA. In an embodiment of the disclosure, the gate driver 210 is configured to include first and second gate drivers 211 and 212 arranged on both sides of the display area DA, e.g., on the left and right sides of the display area DA. The gate driver 210 may be formed in the non-display area NDA and directly on the substrate of the display panel DP. This gate driver 210 may be referred to as a gate-in panel (GIP) structure. In this case, the gate driver 210 may be formed during the process of forming elements of the display panel DP.

For example, a gate driver 210 configured with a GIP structure may include a scan driver circuit that outputs a scan signal and a light emitting driver circuit that outputs a light emitting control signal.

Each of the scan driver circuit and the light emitting driver circuit may be configured with a shift register including a plurality of stages that output the corresponding signals.

For example, the panel driver circuit PDC may be configured with a driver IC (DIC) and a flexible circuit film (or a circuit film) (FPC) on which the driver IC (DIC) is mounted.

The panel driving circuit PDC configured in this manner can be attached to a non-display area NDA on one side of the display panel DP, for example, an upper non-display area NDA, through a connecting medium such as an anisotropic conductive film ACF, and output a panel driving signal for image display to the display panel DP.

As another example, the driving IC (DIC) can be configured to be directly mounted on the substrate of the display panel DP.

A pad area PA may be formed in the upper non-display area NDA of the display panel DP. A plurality of pads PD are arranged along one direction, e.g., a horizontal direction, and in the pad area PA. A panel driving circuit (PDC) may be attached to the pad area (PA).

For example, driving signals output from the panel driving circuit (PDC) for image display may be applied to the plurality of pads PD. In this regard, a flexible printed circuit film (FPC) of the panel driving circuit (PDC) may be provided with a plurality of output bumps that output the driving signals, and the plurality of output bumps may be connected to a plurality of corresponding pads PD.

The plurality of pads PD may include, for example, at least one voltage pad to which a driving voltage (e.g., a low-potential driving voltage) is applied, at least one control pad to which a control signal is applied, and multiple data pads to which data signals are applied.

For example, the control pad may be connected to the gate driver 210 and receive and provide a gate control signal that controls the gate driver 210.

For example, the plurality of data pads may include red, green, and blue data pads to which red, green, and blue data signals are respectively applied. These data pads may be connected to corresponding data lines and may receive and provide data signals.

The display panel DP may have a bending area BA set in an upper (lower) non-display area NDA where a pad area PA is positioned. For example, the bending area BA may be disposed between the pad area PA and the display area DA. In this case, the display panel DP may be bent along the bending area PA, and a portion of the non-display area NDA positioned above the bending area BA may be folded toward the rear of the display panel DP. Accordingly, the pad area PA and a panel driving circuit (PDC) attached thereto may be positioned at the rear of the display panel DP. The bending is only made during manufacturing and packaging the display device. Once the manufacturing is finished, the bending area is not moved or bent anymore as it is fully fixed inside the housing.

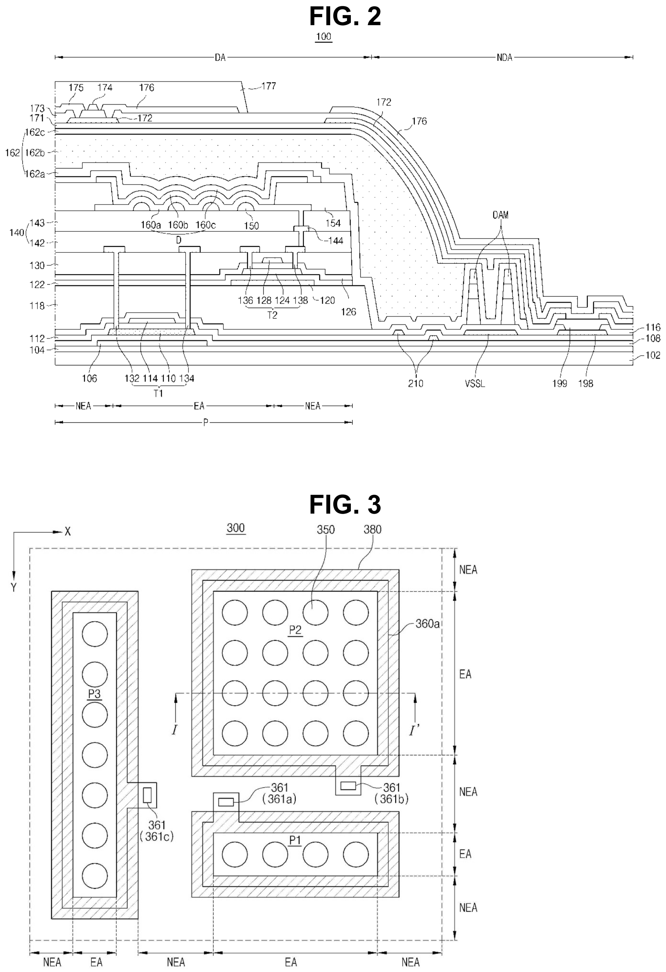

FIG. 2 is a schematic cross-sectional view illustrating a light emitting diode display device of the disclosure.

As shown in FIG 2 with FIG. 1, a light emitting diode display device 100 includes a substrate 102 including a pixel region P, a planarization layer 140 on the substrate 102, a plurality of domes 150 corresponding to the pixel region P and disposed on the planarization layer 140, a light emitting diode D corresponding to the plurality of domes and disposed on the planarization layer 140 and a bank (e.g., a pixel definition layer) 154 corresponding to a boundary of the pixel region P and disposed on the planarization layer 140. The planarization layer 140 corresponds to an emission area EA and an non-emission area NEA between adjacent emission areas EA.

The substrate 102 includes a display area DA and a non-display area NDA outside the display area DA. For example, the non-display area NDA may surround the display area DA. A plurality of pixel regions P are defined in the display area DA, and an emission area EA and a non-emission area NEA are defined in each pixel region P.

The substrate 102 may be a glass substrate or a plastic substrate. For example, the substrate 102 may be one of a polyimide (PI) substrate, a polyethersulfone (PES) substrate, a polyethylenenaphthalate (PEN) substrate, a polyethylene terephthalate (PET) substrate and a polycarbonate (PC) substrate.

In an embodiment of the disclosure, the substrate 102 may have a triple-layered structure including a first polyimide (PI) layer, a second PI layer and an interlayer inorganic layer between the first and second PI layers.

A first buffer layer 104 is disposed on the substrate 102. The moisture and/or oxygen can be blocked by the first buffer layer 104. For example, the first buffer layer 104 may be formed of an inorganic insulating material, e.g., silicon oxide or silicon nitride, and have a single-layered structure or a multi-layered structure.

A first light shielding pattern 106 is disposed on the first buffer layer 104. The light through the substrate 102 can be blocked by the first light shielding pattern 106. For example, the first light shielding pattern 106 may be formed of a metallic material, e.g., molybdenum (Mo), aluminum (Al), chromium (Cr), gold (Au), titanium (Ti), nickel (Ni), neodymium (Nd), copper (Cu) or their alloy, and have a single-layered structure or a multi-layered structure.

A second buffer layer 108 covering the first light shielding pattern 106 is disposed over the substrate 102. The moisture and/or oxygen can be blocked by the second buffer layer 108. For example, the second buffer layer 108 may be formed of an inorganic insulating material, e.g., silicon oxide or silicon nitride, and have a single-layered structure or a multi-layered structure.

A first semiconductor layer 110 corresponding to the first light shielding pattern 106 is disposed on the second buffer layer 108. The first semiconductor layer 110 may include one of a poly-semiconductor material, an amorphous semiconductor material and an oxide semiconductor material. When the first light shielding pattern 106 and the second buffer layer 108 are omitted, the first semiconductor layer 110 may be directly disposed on the first buffer layer 104 or the substrate 102 without the first buffer layer 104.

In an embodiment of the disclosure, the first semiconductor layer 110 may be formed of a poly-semiconductor material, e.g., polycrystalline silicon. The first semiconductor layer 110 may include a first channel region, a first source region at one side of the first channel region and a first drain region at the other side of the first channel region. Impurities may be dopped into the first source and drain regions.

A first gate insulating layer 112 covering the first semiconductor layer 110 is disposed over the second buffer layer 108. The first gate insulating layer 112 may be formed of an inorganic insulating material, e.g., silicon oxide or silicon nitride, and have a single-layered structure or a multi-layered structure.

A first gate electrode 114 corresponding to the first channel region of the first semiconductor layer 110 is disposed on the first gate insulating layer 112. A first capacitor electrode, which is spaced apart from the first gate electrode 114, is disposed on the first gate insulating layer 112.

The first gate electrode 114 and the first capacitor electrode may be disposed on the same layer and be formed of the same material. For example, each of the first gate electrode 114 and the first capacitor electrode may be formed of a metallic material, e.g., Mo, Al, Cr, Au, Ti, Ni, Nd, Cu or their alloy, and have a single-layered structure or a multi-layered structure.

A first interlayer insulating layer 116 covering the first gate electrode 114 and the first capacitor electrode is disposed on the first gate insulating layer 112. The first interlayer insulating layer 116 may be formed of an inorganic insulating material, e.g., silicon oxide or silicon nitride, and have a single-layered structure or a multi-layered structure.

A third buffer layer 118 is disposed on the first interlayer insulating layer 116, and a second light shielding pattern 120 is disposed on the third buffer layer 118. The light through the substrate 102 can be blocked by the second light shielding pattern 120.

A second capacitor electrode corresponding to the first capacitor electrode 116 may be disposed on the third buffer layer 118. The second capacitor electrode is spaced apart from the second light shielding pattern 120.

The second light shielding pattern 120 and the second capacitor electrode may be disposed on the same layer and be formed of the same material. For example, each of the second light shielding pattern 120 and the second capacitor electrode may be formed of a metallic material, e.g., Mo, Al, Cr, Au, Ti, Ni, Nd, Cu or their alloy, and have a single-layered structure or a multi-layered structure.

A second interlayer insulating layer 122 covering the second light shielding pattern 120 and the second capacitor electrode is disposed on the third buffer layer 118. The external moisture and/or oxygen can be blocked by the second interlayer insulating layer 122. For example, the second interlayer insulating layer 122 may be formed of an inorganic insulating material, e.g., silicon oxide or silicon nitride, or an organic insulating material, e.g., photo-acryl or benzocyclobutene (BCB), and have a single-layered structure or a multi-layered structure.

A second semiconductor layer 124 corresponding to the second light shielding pattern 120 is disposed on the second interlayer insulating layer 122. The second semiconductor layer 124 may include one of a poly-semiconductor material, an amorphous semiconductor material and an oxide semiconductor material.

In an embodiment of the disclosure, the second semiconductor layer 124 may be formed of an oxide semiconductor material, e.g., indium-gallium-zinc oxide (IGZO), zinc oxide (ZnO), tin oxide (SnO2), copper oxide (Cu2O), nickel oxide (NiO), indium-tin-zinc oxide (ITZO) or indium-aluminum-zinc oxide (IAZO).

The second semiconductor layer 124 may include a second channel region, a second source region at one side of the second channel region and a second drain region at the other side of the second channel region. Impurities may be dopped into the second source and drain regions.

A second gate insulating layer 126 covering the second semiconductor layer 124 is disposed over the second interlayer insulating layer 122. The second gate insulating layer 126 may be formed of an inorganic insulating material, e.g., silicon oxide or silicon nitride, and have a single-layered structure or a multi-layered structure.

A second gate electrode 128 corresponding to the second channel region of the second semiconductor layer 124 is disposed on the second gate insulating layer 136. For example, the second gate electrode 128 may be formed of a metallic material, e.g., Mo, Al, Cr, Au, Ti, Ni, Nd, Cu or their alloy, and have a single-layered structure or a multi-layered structure.

A third interlayer insulating layer 130 covering the second gate electrode 128 is disposed on the second gate insulating layer 126. The third interlayer insulating layer 130 may be formed of an inorganic insulating material, e.g., silicon oxide or silicon nitride, and have a single-layered structure or a multi-layered structure.

A first source electrode 132, a first drain electrode 134, a second source electrode 136 and a second drain electrode 138 are disposed on the third interlayer insulating layer 130.

The first source electrode 132 and the first drain electrode 134 are respectively connected to the first source region and the first drain region via contact holes through the third interlayer insulating layer 130, the second gate insulating layer 126, the second interlayer insulating layer 122, the third buffer layer 118, the first interlayer insulating layer 116 and the first gate insulating layer 112. The first drain electrode 134 may be connected to the first capacitor electrode.

The second source electrode 136 and the second drain electrode 138 are respectively connected to the second source region and the second drain region via contact holes through the third interlayer insulating layer 130 and the second gate insulating layer 126. The second drain electrode 138 may be connected to the second capacitor electrode.

The first source and drain electrodes 132 and 134 and the second source and drain electrodes 136 and 138 may be disposed on the same layer and formed of the same material. For example, each of the first source and drain electrodes 132 and 134 and the second source and drain electrodes 136 and 138 may be formed of a metallic material, e.g., Mo, Al, Cr, Au, Ti, Ni, Nd, Cu or their alloy, and have a single-layered structure or a multi-layered structure.

The first semiconductor layer 110, the first gate electrode 114, the first source electrode 132 and the first drain electrode 134 constitute a first TFT T1, and the second semiconductor layer 124, the second gate electrode 128, the second source electrode 136 and the second drain electrode 138 constitute a second TFT T2. For example, the first TFT T1 may be a switching TFT, and the second TFT may be a driving TFT. The first and second capacitor electrodes constitute a storage capacitor.

The light emitting diode display device of the disclosure includes the first and second TFTs T1 and T2. Each of the first semiconductor layer 110 of the first TFT T1 and the second semiconductor layer 124 of the second TFT T2 may include one of a poly-semiconductor material, an amorphous semiconductor material and an oxide semiconductor material, and at least one of the first semiconductor layer 110 of the first TFT T1 and the second semiconductor layer 124 of the second TFT T2 may include the oxide semiconductor material. In an exemplary embodiment of the present disclosure, the first semiconductor layer 110 of the first TFT T1 may be formed of the poly-semiconductor material, e.g., polycrystalline silicon, and the second semiconductor layer 124 of the second TFT T2 may be formed of the oxide semiconductor material.

In FIG. 2, the first gate electrode 114, the first source electrode 132 and first drain electrode 134 are disposed over the first semiconductor layer 110, and the second gate electrode 128, the second source electrode 136 and the second drain electrode 138 are disposed over the second semiconductor layer 124. Namely, each of the first and second TFTs T1 and T2 has a coplanar structure. Alternatively, in each of the first and second TFTs T1 and T2, a gate electrode may be disposed under a semiconductor layer, and a source and a drain electrode may be disposed over the semiconductor layer. Namely, each of the TFTs T1 and T2 may have an inverted-staggered structure.

A planarization layer 140 covering the first source and drain electrodes 132 and 134 and the second source and drain electrodes 136 and 138 is disposed on the third interlayer insulating layer 130. The planarization layer 140 may be formed of an organic insulating material, e.g., photo-aryl or BCB.

The planarization layer 140 may include a first planarization layer 142 on the first source and drain electrodes 132 and 134 and the second source and drain electrodes 136 and 138 and a second planarization layer 143 on the first planarization layer 142. A material of the first planarization layer 142 and a material of the second planarization layer 143 may be same or different.

A connection electrode 144 corresponding to the second source electrode 136 is disposed on the first planarization layer 142, and the connection electrode 144 may connected to the second drain electrode 138 through a contact hole in the first planarization layer 142. For example, the connection electrode 144 may be formed of a metallic material, e.g., Mo, Al, Cr, Au, Ti, Ni, Nd, Cu or their alloy, and have a single-layered structure or a multi-layered structure.

The second planarization layer 143 covering the connection electrode 144 is disposed on the first planarization layer 142, and the plurality of domes 150, which are spaced apart from each other and correspond to the emission area EA, are disposed on the second planarization layer 143.

Each dome 150 may include an organic insulating material, e.g., photo-acryl or benzocyclobutene (BCB), or an inorganic insulating material, e.g., silicon oxide or silicon nitride.

A first electrode 160a, which covers the dome 150 and corresponds to the emission area EA, is disposed on the second planarization layer 143. The first electrode 160a corresponds to the connection electrode 148 and is connected to the connection electrode 148 through a contact hole in the second planarization layer 143.

The first electrode 160a is separately formed in each pixel region P. The first electrode 160a may be an anode and may include a transparent conductive oxide (TCO) layer, which is formed of a conductive material, e.g., a transparent conductive oxide material, having a relatively high work function, and a reflective layer.

For example, the transparent conductive oxide material may include at least one of indium-tin-oxide (ITO), indium-zinc-oxide (IZO), indium-tin-zinc oxide (ITZO), tin oxide (SnO), zinc oxide (ZnO), indium-copper-oxide (ICO) and aluminum-zinc-oxide (Al:ZnO, AZO), and the reflective layer may include at least one of silver (Ag), an alloy of Ag and one of palladium (Pd), Cu, In and Nd and aluminum-palladium-copper alloy (APC). For example, the first electrode 160a may have a double-layered structure of Ag/ITO or APC/ITO or a triple-layered structure of ITO/Ag/ITO or ITO/APC/ITO.

A shape of the domes 150 is reflected onto the first electrode 160a so that the first electrode 160a has an uneven surface. For example, the first electrode 160a has a lens shape in correspondence to the dome 150 and a flat surface in correspondence to a space between adjacent domes 150.

A bank (e.g., pixel definition layer) 154 is formed on the second planarization layer 143 at a boundary of the pixel region P. Namely, the bank 154 is positioned in the non-emission area NEA. The bank 154 covers an edge of the first electrode 160a and has an opening to expose a center of the first electrode 160a. Namely, the opening of the bank 154 exposes the first electrode 160a in an emission area EA. The bank 154 may be formed of an organic insulating material, e.g., photo-acryl, BCB or polyimide, and may have a single-layered structure or a multi-layered structure.

The connection electrode 144 overlaps the bank 154. Namely, a contact hole for connection of the first electrode 160a and the connection electrode 144 may be covered by the bank 154.

Although not shown, a spacer may be disposed on the bank 154. The spacer 154 may have an area being smaller than the bank 154. For example, the spacer may be formed of an organic insulating material, e.g., photo-acryl, BCB or polyimide, and may have a single-layered structure or a multi-layered structure.

A light emitting layer 160b covering the first electrode 160a and the bank 154 is provided. The light emitting layer 160b contacts the first electrode 160a in the opening of the bank 154. The light emitting layer 160b may be formed to contact an upper surface of the first electrode 160a and an upper surface and a side surface of the bank 154.

For example, the light emitting layer 160b may include an organic emitting material layer (EML) including a host and a dopant. The light emitting layer 160b may further include at least one of a hole injection layer (HIL), a hole transporting layer (HTL), an electron blocking layer (EBL), a hole blocking layer (HBL), an electron transporting layer (ETL) and an electron injection layer (EIL) to have a multi-layered structure. Alternatively, the EML may include an inorganic emitting material, e.g., a quantum dot. Namely, the light emitting diode display device 100 of the present disclosure may be an organic light emitting diode display device or an inorganic light emitting diode display device.

A shape of the domes 150 is reflected onto the light emitting layer 160b so that the light emitting layer 160b has an uneven surface. For example, the light emitting layer 160b has a lens shape in correspondence to the dome 150 and a flat surface in correspondence to a space between adjacent domes 150.

A second electrode 160c is formed over the substrate 102 where the light emitting layer 160b is formed. The second electrode 160c covers an entire surface of the display area DA. The second electrode 160c may be formed of at least one of ITO, IZO, Al, Ag, Cu, Pb, magnesium (Mg), Mo, Ti and their alloy and have a single-layered structure or a multi-layered structure. The second electrode 160c may have a thin profile (small thickness) to provide a light transmittance property (or a semi-transmittance property).

A shape of the domes 150 is reflected onto the second electrode 160c so that the second electrode 160c has an uneven surface. For example, the second electrode 160c has a lens shape in correspondence to the dome 150 and a flat surface in correspondence to a space between adjacent domes 150. So the layers 160a, 160b, 160c of the light emitting device D have a concave/ convex shape as the layers follow the shape of the domes 150 in the emission area EA.

The first electrode 160a, the light emitting layer 160b and the second electrode 160c constitute a light emitting diode D. The organic light emitting diode D may emit the red, green and blue light in the red, green and blue pixel region, respectively.

In the light emitting display device 100, the light from the light emitting layer 160b passes through the second electrode 160c to display an image. Namely, the light emitting display device 100 of the disclosure is a top-emission type display device.

An encapsulation layer 162 is formed on the second electrode 160c to prevent penetration of moisture into the light emitting diode D. The encapsulation layer 162 may cover an entire substrate 102. The encapsulation layer 162 may have a multi-layered structure including a first inorganic layer 162a, an organic layer 162b and a second insulating layer 162c sequentially stacked.

Each of the first and second inorganic layers 162a and 162c may be formed of an inorganic insulating material, e.g., silicon oxide or silicon nitride. The organic layer 162b may be formed of an organic insulating material, e.g., acryl resin, epoxy resin, phenolic resin, polyamide resin or polyimide resin.

A fourth buffer layer 171 is disposed on the encapsulation layer 162 and over an entire surface of the substrate 102. The moisture and/or oxygen can be blocked by the fourth buffer layer 171. For example, the fourth buffer layer 171 may be formed of an inorganic insulating material, e.g., silicon oxide or silicon nitride, and have a single-layered structure or a multi-layered structure.

A dam DAM, a low-potential driving voltage line VSSL, a gate driving unit 210 having a GIP structure and first and second touch pads 198 and 199 are disposed in the non-display area NDA. The low-potential driving voltage line VSSL may be positioned between the display area DA and the touch pads 198 and 199, the gate driving unit 210 may be positioned between the display area DA and the low-potential driving voltage line VSSL. The dam DAM may overlap the low-potential driving voltage line VSSL and may be positioned on the low-potential driving voltage line VSSL.

For example, the organic layer 162b of the encapsulation layer 162 is formed by a solution process, and an over-flow of the solution for the organic layer 162b can be prevented by the dam DAM. The dam DAM may be formed to surround the organic layer 162b of the encapsulation layer 162.

For example, the encapsulation layer 162b may have a triple-layered structure including a first layer, which is formed of the same material and disposed on the same layer as the third buffer layer 118, a second layer, which is formed of the same material and disposed on the same layer as the first planarization layer 141, and a third layer, which is formed of the same material and disposed on the same layer as the second planarization layer 143, but it is not limited thereto.

The low-potential driving voltage line VSSL may be connected to the second electrode 160c to provide a low-potential driving voltage.

The display device may be further equipped with a touch functionality.

A first connection line 172 is disposed on the fourth buffer layer 171, and a fourth interlayer insulating layer 173 covering the first connection line 172 is disposed on the fourth buffer layer 171.

A second connection line 174 and first and second touch electrodes 175 and 176 are disposed on the fourth interlayer insulating layer 173. The first and second touch electrodes 175 and 176 contacts the first connection line 172 through a contact hole in the fourth interlayer insulating layer 173 to be electrically connected to each other.

A portion of the first and second touch electrodes 175 and 176 and a portion of the first connection line 172 extend through a side surface of the encapsulation layer 162 to be electrically connected to a touch driving circuit through the first and second touch pads 198 and 199 in the non-display area NDA.

A touch protection layer 177 may be disposed on the first and second touch electrodes 175 and 176 and the second connection line 174. In FIG. 2, the touch protection layer 177 is disposed on a part of the display area DA. Alternatively, the touch protection layer 177 may extend into the non-display area NDA.

Although not shown, a color filter layer may be disposed on the touch protection layer 177. The color filter layer may include red, green and blue color filter patterns respectively corresponding to the red, green and blue pixel regions.

In the light emitting diode display device 100 of the disclosure, the domes 150 corresponding to the first electrode 160a are disposed on the second planarization layer 143 so that a viewing angle is enlarged.

However, the control of the viewing angle by the domes 150 is very difficult. When the viewing angle is too broad, the brightness in a front viewing angle is decreased. Moreover, the light from the light emitting layer 160b toward a side direction may be reflected (or scattered) by the domes 150 so that a color mixture problem may occur.

FIG. 3 is a schematic cross-sectional view illustrating one unit pixel of a light emitting diode display device of the disclosure.

Referring to FIG. 3, an unit pixel of a light emitting diode display device 300 may include a first pixel P1 extending along a first direction X, a second pixel P2 spaced apart from the first pixel P1 in a second direction Y and a third pixel P3 is disposed at one side of the first and second pixels P1 and P2 in the first direction X.

For example, first pixel P1 may be a red pixel, the second pixel P2 may be a green pixel, and the third pixel P3 may be a blue pixel.

The first pixel P1 may have a rectangular shape with a major axis in the first direction X, and the third pixel P3 may have a rectangular shape with a major axis in the second direction Y. The second pixel P2 may have a square shape. In the first direction X, the first and second pixels P1 and P2 may face each other. In the second direction Y, the second and third pixels P2 and P3 may face each other.

Each of the first to third pixels P1, P2 and P3 includes an emission area EA. An edge of each of the first to third pixels P1, P2 and P3 and a space between the first to third pixels P1, P2 and P3 are defined as a non-emission area NEA.

A plurality of domes 150 are disposed in the emission area EA of each of the first to third pixels P1, P2 and P3. A first electrode 360a of a light emitting diode is disposed in the emission area EA of each of the first to third pixels P1, P2 and P3.

The first electrode 360a is electrically connected to the drain electrode 138 (of FIG. 2) of the second TFT T2 (of FIG. 2) by contacting the connection electrode 144 (of FIG. 2) through a contact hole 361 (of FIG. 3) in the second planarization layer. In FIG. 3, the contact hole 361 is positioned outside a partition wall 380, but it is not limited thereto. For example, the contact hole 361 may be positioned to overlap the partition wall 380.

A position of the contact hole 361 for connection of the first electrode 360a and the connection electrode 144 may be different in the pixels P1, P2 and P3. However, a position of the contact hole in the pixels P1, P2 and P3 is not limited thereto.

In an embodiment of the present disclosure, the contact hole 361a for connection of the first electrode 360a and the connection electrode 144 or the thin film transistor in the first pixel P1 may be positioned at a side of the first pixel P1 toward the second pixel P2. The contact hole 361b for connection of the first electrode 360a and the connection electrode 144 or the thin film transistor in the second pixel P2 may be positioned at a side of the second pixel P2 toward the first pixel P1. Namely, the contact hole 361a in the first pixel P1 and the contact hole 361b in the second pixel P2 may be positioned between the first and second pixels P1 and P2.

The contact hole 361c for connection of the first electrode 360a and the connection electrode 144 or the thin film transistor in the third pixel P3 may be positioned at a side of the third pixel P3 toward the first and second pixels P1 and P2. Alternatively, the contact hole 361c for connection of the first electrode 360a and the connection electrode 144 in the third pixel P3 may be positioned at a side of the third pixel P3 being opposite to the first and second pixels P1 and P2.

In FIG. 3, the contact hole 361a in the first pixel P1, the contact hole 361b in the second pixel P2 and the contact hole 361c in the third pixel P3 are disposed in a line, but it is not limited thereto.

A partition wall 380 surrounding the first to third pixels P1, P2 and P3 are disposed in the non-emission area NEA.

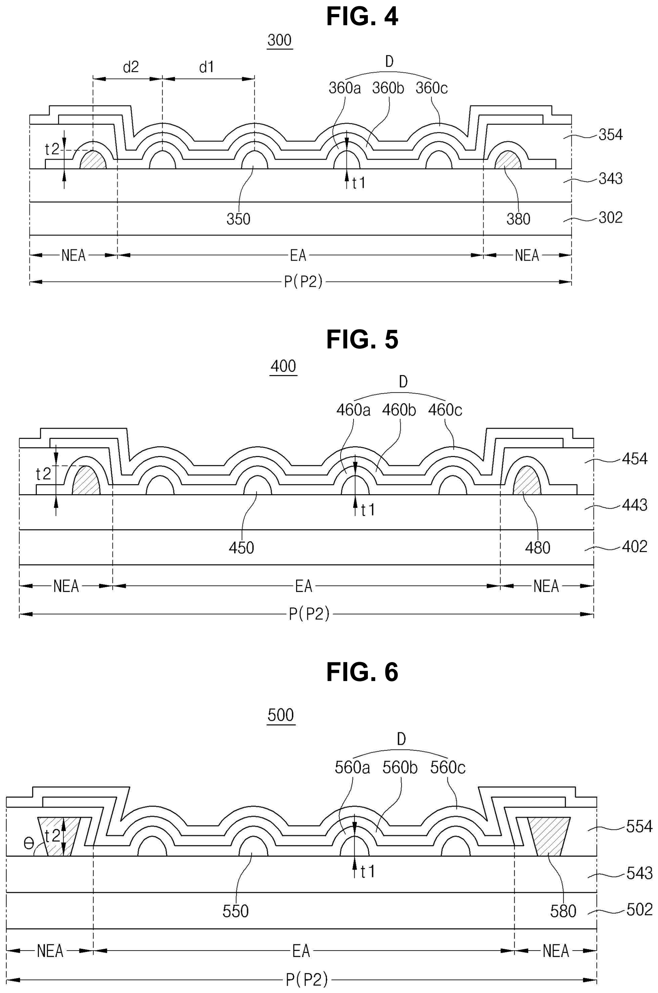

FIG. 4 is a schematic cross-sectional view illustrating a light emitting diode display device according to a first embodiment of the present disclosure. FIG. 4 is a schematic cross-sectional view taken along the line I-I' in FIG. 3.

For convenience of the explanation, the element between the substrate 302 and the second planarization layer 343, the elements over the light emitting diode D and the connection electrode 144 (of FIG. 2) are omitted.

As shown in FIG. 4, a light emitting diode display device 300 includes a second planarization layer 343 on the substrate 302, a plurality of domes 350 disposed on the second planarization layer 343 and corresponding to the emission area EA, a partition wall 380 disposed on the second planarization layer 343 and corresponding to the non-emission area NEA and a bank 354 covering the partition wall 380 and corresponding to the non-emission area NEA.

The domes 350 are spaced apart from each other. The domes 350 may be spaced apart from each other by a first distance d1.

The domes 350 may include an organic insulating material, e.g., photo-acryl or benzocyclobutene (BCB), or an inorganic insulating material, e.g., silicon oxide or silicon nitride.

The partition wall 380 is disposed in the non-emission area NEA and spaced apart from the domes 350. The partition wall 380 has a shape being substantially same as the dome 350. Namely, the partition wall 380 may have a lens shape or a dome shape. However, s shape of the partition wall 380 is not limited thereto.

Each dome 350 has a first thickness t1, and the partition wall 380 has a second thickness t2 being substantially same as the first thickness t1. In other words, each dome 350 has a first height from the substrate 302, and the partition wall 380 has a second height, which is substantially same as the first height, from the substrate 302.

The partition wall 380 may be spaced apart from the dome 350 by a second distance d2, which is smaller than the first distance d1. Namely, a distance d2 between the dome 350 at an end of the emission area EA and the partition wall 380 may be smaller than a distance d1 between adjacent domes 350.

When a distance d1 between adjacent domes 350 is smaller than a distance d2 between the dome 350 and the partition wall 380, the light may be trapped in adjacent domes 350 so that the emission efficiency may be decreased. When a distance d2 between the dome 350 and the partition wall 380 is greater than a distance d1 between adjacent domes 350, a viewing angle at an edge of the emission area EA may be too wide or the light leakage may occur at an edge of the emission area EA. However, in the light emitting diode display device 300, since the distance d2 between the dome 350 at an end of the emission area EA and the partition wall 380 is smaller than the distance d1 between adjacent domes 350, the above problems can be prevented.

In an embodiment of the present disclosure, the partition wall 380 may be spaced apart from the dome 350 by a second distance d2, which is substantially same as the first distance d1.

The partition wall 380 may include an organic insulating material, e.g., photo-acryl or benzocyclobutene (BCB), or an inorganic insulating material, e.g., silicon oxide or silicon nitride. For example, the partition wall 380 may be formed of the same material as the plurality of domes 350.

The first electrode 360a is separately formed in each pixel region P. The first electrode 360a may be an anode and may include a transparent conductive oxide (TCO) layer, which is formed of a conductive material, e.g., a transparent conductive oxide material, having a relatively high work function, and a reflective layer.

A shape of domes 350 is reflected onto the first electrode 360a so that the first electrode 360a has an uneven surface. For example, the first electrode 360a has a lens shape in correspondence to the dome 350 and a flat surface in correspondence to a space between adjacent domes 350.

The first electrode 360a is disposed on the partition wall 380. A shape of the partition wall 380 is reflected onto the first electrode 360a so that the first electrode 360a has an uneven surface. For example, the first electrode 360a has a lens shape in correspondence to the partition wall 380 and a flat surface in correspondence to a space between the partition wall 380 and the dome 350. The first electrode 360a may cover the second planarization layer 343 in the emission area EA, the domes 350 and at least a portion of the partition wall 380. In other words, the first electrode 360a may cover the second planarization layer 343 in one of the plurality of emission areas EA, one or more of plurality of the domes 350 and at least a portion of the partition wall 380.

A bank 354 is formed on the second planarization layer 343 at a boundary of the pixel region P. Namely, the bank 354 is positioned in the non-emission area NEA. The bank 354 covers an edge of the first electrode 360a and has an opening to expose a center of the first electrode 360a. Namely, the opening of the bank 354 exposes the first electrode 360a in an emission area EA. The bank 354 may be formed of an organic insulating material, e.g., photo-acryl, BCB or polyimide, and may have a single-layered structure or a multi-layered structure.

The bank 354 covers the partition wall 380. An end of the bank 354 may be positioned on a flat surface of the second planarization layer 343 between the partition wall 380 and the dome 350. In an embodiment of the present disclosure, the end of the bank 354 may be closer to the partition wall 380 than the dome 350.

A light emitting layer 360b covering the first electrode 360a and the bank 354 is provided. The light emitting layer 360b contacts the first electrode 360a in the opening of the bank 354. The light emitting layer 360b may be formed to contact an upper surface of the first electrode 360a and an upper surface and a side surface of the bank 354.

A shape of the domes 350 is reflected onto the light emitting layer 360b so that the light emitting layer 360b has an uneven surface. For example, the light emitting layer 360b has a lens shape in correspondence to the dome 350 and a flat surface in correspondence to a space between adjacent domes 350.

A second electrode 360c is formed over the substrate 302 where the light emitting layer 360b is formed. The second electrode 360c covers an entire surface of the display area DA. The second electrode 360c may be formed of at least one of ITO, IZO, Al, Ag, Cu, Pb, magnesium (Mg), Mo, Ti and their alloy and have a single-layered structure or a multi-layered structure. The second electrode 360c may have a thin profile (small thickness) to provide a light transmittance property (or a semi-transmittance property).

A shape of the domes 350 is reflected onto the second electrode 360c so that the second electrode 360c has an uneven surface. For example, the second electrode 360c has a lens shape in correspondence to the dome 350 and a flat surface in correspondence to a space between adjacent domes 350.

The first electrode 360a, the light emitting layer 360b and the second electrode 360c constitute a light emitting diode D. The organic light emitting diode D may emit the red, green and blue light in the red, green and blue pixel region, respectively.

In the light emitting display device 300, the light from the light emitting layer 360b passes through the second electrode 360c to display an image. Namely, the light emitting display device 300 of the present disclosure is a top-emission type display device.

In the light emitting diode display device 300 of the disclosure, the domes 350 corresponding to the first electrode 360a are disposed on the second planarization layer 343 so that a viewing angle is enlarged.

The partition wall 380 is disposed in the non-emission area NEA, and the first electrode 360a covers the partition wall 380 to have a lens shape. Accordingly, a viewing angle can be controlled by the partition wall 380 and the first electrode 360a covering the partition wall 380, and the light toward adjacent pixel region can be blocked so that a color mixture problem can be prevented.

Moreover, a distance between the dome 350 and the partition wall 380 is smaller than a distance between adjacent domes 350. As a result, the viewing angle can be controlled, and the brightness in a front view can be maximized.

FIG. 5 is a schematic cross-sectional view illustrating a light emitting diode display device according to a second embodiment of the present disclosure. FIG. 5 is a schematic cross-sectional view taken along the line I-I' in FIG. 3.

For convenience of the explanation, the element between the substrate 402 and the second planarization layer 443, the elements over the light emitting diode D and the connection electrode 144 (of FIG. 2) are omitted.

As shown in FIG. 5, a light emitting diode display device 400 includes a second planarization layer 443 on the substrate 402, a plurality of domes 450 disposed on the second planarization layer 443 and corresponding to the emission area EA, a partition wall 480 disposed on the second planarization layer 443 and corresponding to the non-emission area NEA and a bank 454 covering the partition wall 480 and corresponding to the non-emission area NEA.

The domes 450 are spaced apart from each other. The domes 450 may be spaced apart from each other by a first distance d1.

The domes 450 may include an organic insulating material, e.g., photo-acryl or benzocyclobutene (BCB), or an inorganic insulating material, e.g., silicon oxide or silicon nitride.

The partition wall 480 is disposed in the non-emission area NEA and spaced apart from the domes 450. The partition wall 480 has a shape being substantially same as the dome 450. Namely, the partition wall 480 may have a lens shape or a dome shape.

Each dome 450 has a first thickness t1, and the partition wall 480 has a second thickness t2 being larger than the first thickness t1. In other words, each dome 450 has a first height from the substrate 402, and the partition wall 480 has a second height, which is larger than the first height, from the substrate 402. As a result, the light from the light emitting layer 460b on the dome 450 toward a side direction can be efficiently blocked by the partition wall 480.

In FIG. 5, the plurality of domes 450 have the same thickness. In an embodiment of the disclosure, the dome 450 in a center of the emission area EA may have a thickness being smaller than the dome 450 in an edge of the emission area EA. For example, a thickness of the domes 450 may be gradually increased from a center of the emission area EA to an edge of the emission area EA.

In an embodiment of the disclosure, the dome 450 includes a first dome and a second dome between the first dome and the partition wall 480, and a thickness of the second dome may be larger than that of the first dome. A thickness of the second dome may be smaller than that of the partition wall 480. In this case, a viewing angle in a center of the emission area EA can be maximized, and a viewing angle can be easily adjusted (controlled) by the domes 450 having different thicknesses.

When a distance d1 between adjacent domes 450 is smaller than a distance d2 between the dome 450 and the partition wall 480, the light may be trapped in adjacent domes 450 so that the emission efficiency may be decreased. When a distance d2 between the dome 450 and the partition wall 480 is greater than a distance d1 between adjacent domes 450, a viewing angle at an edge of the emission area EA may be too wide or the light leakage may occur at an edge of the emission area EA. However, in the light emitting diode display device 400, since the distance d2 between the dome 450 at an end of the emission area EA and the partition wall 480 is smaller than the distance d1 between adjacent domes 450, the above problems can be prevented.

In an embodiment of the present disclosure, the partition wall 480 may be spaced apart from the dome 450 by a second distance d2, which is substantially same as the first distance d1.

The partition wall 480 may include an organic insulating material, e.g., photo-acryl or benzocyclobutene (BCB), or an inorganic insulating material, e.g., silicon oxide or silicon nitride. For example, the partition wall 480 may be formed of the same material as the plurality of domes 450.

The first electrode 460a is separately formed in each pixel region P. The first electrode 460a may be an anode and may include a transparent conductive oxide (TCO) layer, which is formed of a conductive material, e.g., a transparent conductive oxide material, having a relatively high work function, and a reflective layer.

A shape of domes 450 is reflected onto the first electrode 460a so that the first electrode 460a has an uneven surface. For example, the first electrode 460a has a lens shape in correspondence to the dome 450 and a flat surface in correspondence to a space between adjacent domes 450.

The first electrode 460a is disposed on the partition wall 480. A shape of the partition wall 480 is reflected onto the first electrode 460a so that the first electrode 460a has an uneven surface. For example, the first electrode 460a has a lens shape in correspondence to the partition wall 480 and a flat surface in correspondence to a space between the partition wall 480 and the dome 450.

A bank 454 is formed on the second planarization layer 443 at a boundary of the pixel region P. Namely, the bank 454 is positioned in the non-emission area NEA. The bank 454 covers an edge of the first electrode 460a and has an opening to expose a center of the first electrode 460a. Namely, the opening of the bank 454 exposes the first electrode 460a in an emission area EA. The bank 454 may be formed of an organic insulating material, e.g., photo-acryl, BCB or polyimide, and may have a single-layered structure or a multi-layered structure.

The bank 454 covers the partition wall 480. An end of the bank 454 may be positioned on a flat surface of the second planarization layer 443 between the partition wall 480 and the dome 450. In an embodiment of the present disclosure, the end of the bank 454 may be closer to the partition wall 480 than the dome 450.

A light emitting layer 460b covering the first electrode 460a and the bank 454 is provided. The light emitting layer 460b contacts the first electrode 460a in the opening of the bank 454. The light emitting layer 460b may be formed to contact an upper surface of the first electrode 460a and an upper surface and a side surface of the bank 454.

A shape of the domes 450 is reflected onto the light emitting layer 460b so that the light emitting layer 460b has an uneven surface. For example, the light emitting layer 460b has a lens shape in correspondence to the dome 450 and a flat surface in correspondence to a space between adjacent domes 450.

A second electrode 460c is formed over the substrate 402 where the light emitting layer 460b is formed. The second electrode 460c covers an entire surface of the display area DA. The second electrode 460c may be formed of at least one of ITO, IZO, Al, Ag, Cu, Pb, magnesium (Mg), Mo, Ti and their alloy and have a single-layered structure or a multi-layered structure. The second electrode 460c may have a thin profile (small thickness) to provide a light transmittance property (or a semi-transmittance property).

A shape of the domes 450 is reflected onto the second electrode 460c so that the second electrode 460c has an uneven surface. For example, the second electrode 460c has a lens shape in correspondence to the dome 450 and a flat surface in correspondence to a space between adjacent domes 450.

The first electrode 460a, the light emitting layer 460b and the second electrode 460c constitute a light emitting diode D. The organic light emitting diode D may emit the red, green and blue light in the red, green and blue pixel region, respectively.

In the light emitting display device 400, the light from the light emitting layer 460b passes through the second electrode 460c to display an image. Namely, the light emitting display device 400 of the present disclosure is a top-emission type display device.

In the light emitting diode display device 400 of the present disclosure, the domes 450 corresponding to the first electrode 460a are disposed on the second planarization layer 443 so that a viewing angle is enlarged.

The partition wall 480 is disposed in the non-emission area NEA, and the first electrode 460a covers the partition wall 480 to have a lens shape. Accordingly, a viewing angle can be controlled by the partition wall 480 and the first electrode 460a covering the partition wall 480, and the light toward adjacent pixel region can be blocked so that a color mixture problem can be prevented.

Moreover, the partition wall 480 is thicker than the dome 450 so that a viewing angle can be efficiently controlled.

Furthermore, a distance between the dome 450 and the partition wall 480 is smaller than a distance between adjacent domes 450. As a result, the viewing angle can be controlled, and the brightness in a front view can be maximized.

FIG. 6 is a schematic cross-sectional view illustrating a light emitting diode display device according to a third embodiment of the present disclosure. FIG. 6 is a schematic cross-sectional view taken along the line I-I' in FIG. 3.

For convenience of the explanation, the element between the substrate 502 and the second planarization layer 543, the elements over the light emitting diode D and the connection electrode 144 (of FIG. 2) are omitted.

As shown in FIG. 6, a light emitting diode display device 500 includes a second planarization layer 543 on the substrate 502, a plurality of domes 550 disposed on the second planarization layer 543 and corresponding to the emission area EA, a partition wall 580 disposed on the second planarization layer 543 and corresponding to the non-emission area NEA and a bank 554 covering the partition wall 580 and corresponding to the non-emission area NEA.

The domes 550 are spaced apart from each other. The domes 550 may be spaced apart from each other by a first distance d1.

The domes 550 may include an organic insulating material, e.g., photo-acryl or benzocyclobutene (BCB), or an inorganic insulating material, e.g., silicon oxide or silicon nitride.

The partition wall 580 is disposed in the non-emission area NEA and spaced apart from the domes 550. The partition wall 580 has a reverse-tapered shape. An upper surface of the partition wall 580 is wider than a lower surface of the partition wall 580. A side surface of the partition wall 580 may have an angle θ in a range of about 60 to 80 degrees with respect to the second planarization layer 543.

Each dome 550 has a first thickness t1, and the partition wall 580 has a second thickness t2 being larger than the first thickness t1. In other words, each dome 550 has a first height from the substrate 502, and the partition wall 580 has a second height, which is larger than the first height, from the substrate 502.

In FIG. 6, the plurality of domes 550 have the same thickness. In an embodiment of the present disclosure, the dome 550 in a center of the emission area EA may have a thickness being smaller than the dome 550 in an edge of the emission area EA. For example, a thickness of the domes 550 may be gradually increased from a center of the emission area EA to an edge of the emission area EA.

In an embodiment of the present disclosure, the dome 550 includes a first dome and a second dome between the first dome and the partition wall 580, and a thickness of the second dome may be larger than that of the first dome. A thickness of the second dome may be smaller than that of the partition wall 580. In this case, a viewing angle in a center of the emission area EA can be maximized, and a viewing angle can be easily adjusted (controlled) by the domes 550 having different thicknesses.

When a distance d1 between adjacent domes 550 is smaller than a distance d2 between the dome 550 and the partition wall 580, the light may be trapped in adjacent domes 550 so that the emission efficiency may be decreased. When a distance d2 between the dome 550 and the partition wall 580 is greater than a distance d1 between adjacent domes 550, a viewing angle at an edge of the emission area EA may be too wide or the light leakage may occur at an edge of the emission area EA. However, in the light emitting diode display device 500, since the distance d2 between the dome 550 at an end of the emission area EA and the partition wall 580 is smaller than the distance d1 between adjacent domes 550, the above problems can be prevented.

In an embodiment of the present disclosure, the partition wall 580 may be spaced apart from the dome 550 by a second distance d2, which is substantially same as the first distance d1.

The partition wall 580 may include an organic insulating material, e.g., photo-acryl or benzocyclobutene (BCB), or an inorganic insulating material, e.g., silicon oxide or silicon nitride. For example, the partition wall 580 may be formed of the same material as the plurality of domes 550.

The first electrode 560a is separately formed in each pixel region P. The first electrode 560a may be an anode and may include a transparent conductive oxide (TCO) layer, which is formed of a conductive material, e.g., a transparent conductive oxide material, having a relatively high work function, and a reflective layer.

A shape of domes 550 is reflected onto the first electrode 560a so that the first electrode 560a has an uneven surface. For example, the first electrode 560a has a lens shape in correspondence to the dome 550 and a flat surface in correspondence to a space between adjacent domes 550.

The first electrode 560a is disposed on or covers a side surface of the partition wall 580. The first electrode 560a is presented on one side surface of the partition wall and not presented on an upper surface of the partition wall 580 so that the upper surface of the partition wall is exposed.

When the angle θ between the partition wall 580 and the second planarization layer 543 is smaller than the above range, the first electrode 560a may not be formed on the side surface of the partition wall 580 by a deposition process. In the light emitting diode display device 500 of the present disclosure, a side surface of the partition wall 580 has an angle θ in a range of about 60 to 80 degrees with respect to the second planarization layer 543, and the first electrode 560a can be formed on the side surface of the partition wall 580 and can reflect the light from the light emitting layer 560b.

A bank 554 is formed on the second planarization layer 543 at a boundary of the pixel region P. Namely, the bank 554 is positioned in the non-emission area NEA. The bank 554 covers an edge of the first electrode 560a and has an opening to expose a center of the first electrode 560a. Namely, the opening of the bank 554 exposes the first electrode 560a in an emission area EA. The bank 554 may be formed of an organic insulating material, e.g., photo-acryl, BCB or polyimide, and may have a single-layered structure or a multi-layered structure.

The bank 554 covers the partition wall 580. An end of the bank 554 may be positioned on a flat surface of the second planarization layer 543 between the partition wall 580 and the dome 550. In an embodiment of the present disclosure, the end of the bank 554 may be closer to the partition wall 580 than the dome 550.

A light emitting layer 560b covering the first electrode 560a and the bank 554 is provided. The light emitting layer 560b contacts the first electrode 560a in the opening of the bank 554. The light emitting layer 560b may be formed to contact an upper surface of the first electrode 560a and an upper surface and a side surface of the bank 554.

A shape of the domes 550 is reflected onto the light emitting layer 560b so that the light emitting layer 560b has an uneven surface. For example, the light emitting layer 560b has a lens shape in correspondence to the dome 550 and a flat surface in correspondence to a space between adjacent domes 550.

A second electrode 560c is formed over the substrate 502 where the light emitting layer 560b is formed. The second electrode 560c covers an entire surface of the display area DA. The second electrode 560c may be formed of at least one of ITO, IZO, Al, Ag, Cu, Pb, magnesium (Mg), Mo, Ti and their alloy and have a single-layered structure or a multi-layered structure. The second electrode 560c may have a thin profile (small thickness) to provide a light transmittance property (or a semi-transmittance property).

A shape of the domes 550 is reflected onto the second electrode 560c so that the second electrode 560c has an uneven surface. For example, the second electrode 560c has a lens shape in correspondence to the dome 550 and a flat surface in correspondence to a space between adjacent domes 550.

The first electrode 560a, the light emitting layer 560b and the second electrode 560c constitute a light emitting diode D. The organic light emitting diode D may emit the red, green and blue light in the red, green and blue pixel region, respectively.

In the light emitting display device 500, the light from the light emitting layer 560b passes through the second electrode 560c to display an image. Namely, the light emitting display device 500 of the present disclosure is a top-emission type display device.

In the light emitting diode display device 500 of the present disclosure, the domes 550 corresponding to the first electrode 560a are disposed on the second planarization layer 543 so that a viewing angle is enlarged.

The partition wall 580 is disposed in the non-emission area NEA, and the first electrode 560a covers the partition wall 580 to have a lens shape. Accordingly, a viewing angle can be controlled by the partition wall 580 and the first electrode 560a covering the partition wall 580, and the light toward adjacent pixel region can be blocked so that a color mixture problem can be prevented.

Moreover, the partition wall 580 has a reverse-tapered shape, and the control of a viewing angle can be secured.

Furthermore, a distance between the dome 550 and the partition wall 580 is smaller than a distance between adjacent domes 550. As a result, the viewing angle can be controlled, and the brightness in a front view can be maximized.

Further, the partition wall 580 is thicker than the dome 550 so that a viewing angle can be efficiently controlled.

Further, the dome 550 in an edge of the emission area EA is thicker than the dome 350 in a center of the emission area EA. As a result, the viewing angle can be controlled, and the brightness in a front view can be maximized.

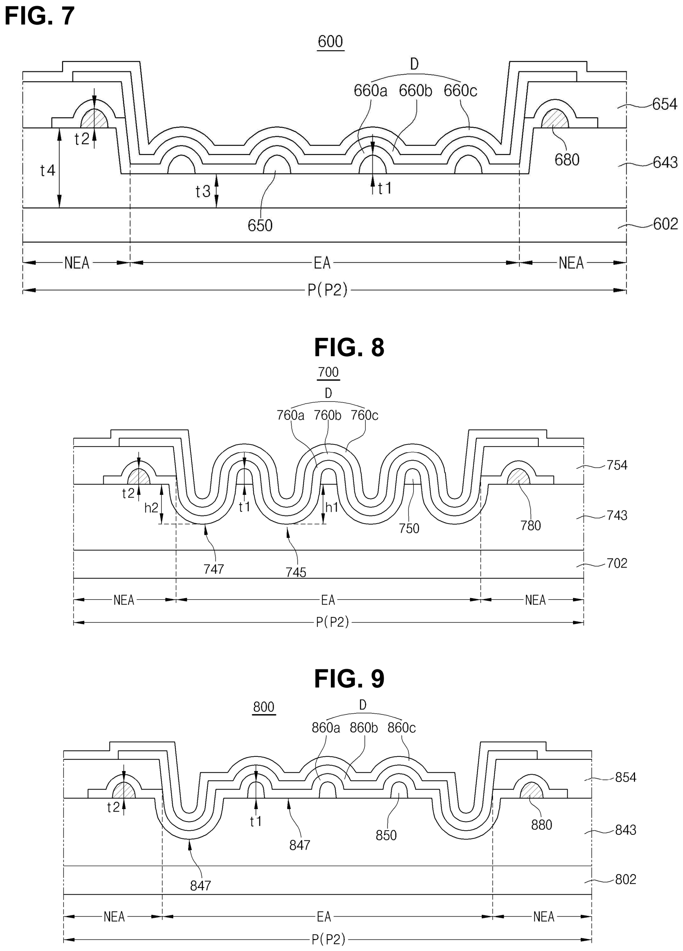

FIG. 7 is a schematic cross-sectional view illustrating a light emitting diode display device according to a fourth embodiment of the present disclosure. FIG. 7 is a schematic cross-sectional view taken along the line I-I' in FIG. 3.

For convenience of the explanation, the element between the substrate 602 and the second planarization layer 643, the elements over the light emitting diode D and the connection electrode 144 (of FIG. 2) are omitted.

As shown in FIG. 7, a light emitting diode display device 600 includes a second planarization layer 643 on the substrate 602, a plurality of domes 650 disposed on the second planarization layer 643 and corresponding to the emission area EA, a partition wall 680 disposed on the second planarization layer 643 and corresponding to the non-emission area NEA and a bank 654 covering the partition wall 680 and corresponding to the non-emission area NEA.

The second planarization layer 643 has a third thickness t3 in the emission area EA and a fourth thickness, which is larger than the third thickness t3, in the non-emission area NEA.

The domes 650 are disposed on the second planarization layer 643 and spaced apart from each other in the emission area EA. The domes 650 may be spaced apart from each other by a first distance d1.

The domes 650 may include an organic insulating material, e.g., photo-acryl or benzocyclobutene (BCB), or an inorganic insulating material, e.g., silicon oxide or silicon nitride.

The partition wall 680 is disposed in the non-emission area NEA and spaced apart from the domes 650. The partition wall 680 has substantially the same shape as the dome 650. The partition wall 680 may have a lens shape or a dome shape.

Each dome 650 has a first thickness t1, and the partition wall 680 has a second thickness t2 being substantially same as the first thickness t1. In other words, each dome 650 has a first height from the substrate 602, and the partition wall 680 has a second height, which is substantially same as the first height, from the substrate 602.

Since the second planarization layer 643 has a third thickness t3 in the emission area EA and a fourth thickness t4, which is larger than the third thickness t3, in the non-emission area NEA, a height of the partition wall 680, which has substantially the same thickness as the dome 650, is larger than that of the dome 650. Accordingly, the light emitting diode display device 600 with the partition wall 680 and the dome 650 having substantially the same thickness provides an effect of a viewing angle control without an increase of a thickness of the device.

In an embodiment of the present disclosure, the second thickness t2 of the partition wall 680 may be larger than the first thickness t1 of the dome 650. In an embodiment of the present disclosure, the second thickness t2 of the partition wall 680 may be smaller than the first thickness t1 of the dome 650 as long as a height of the partition wall 680 from the substrate 602 is larger than a height of the dome 650 from the substrate 602.

In FIG. 7, the plurality of domes 650 have the same thickness. In an embodiment of the present disclosure, the dome 650 in a center of the emission area EA may have a thickness being smaller than the dome 650 in an edge of the emission area EA. For example, a thickness of the domes 650 may be gradually increased from a center of the emission area EA to an edge of the emission area EA.

In an embodiment of the present disclosure, the dome 650 includes a first dome and a second dome between the first dome and the partition wall 680, and a thickness of the second dome may be larger than that of the first dome. A thickness of the second dome may be smaller than that of the partition wall 680. In this case, a viewing angle in a center of the emission area EA can be maximized, and a viewing angle can be easily adjusted (controlled) by the domes 650 having different thicknesses.

When a distance d1 between adjacent domes 650 is smaller than a distance d2 between the dome 650 and the partition wall 680, the light may be trapped in adjacent domes 650 so that the emission efficiency may be decreased. When a distance d2 between the dome 650 and the partition wall 680 is greater than a distance d1 between adjacent domes 650, a viewing angle at an edge of the emission area EA may be too wide or the light leakage may occur at an edge of the emission area EA. However, in the light emitting diode display device 600, since the distance d2 between the dome 650 at an end of the emission area EA and the partition wall 680 is smaller than the distance d1 between adjacent domes 650, the above problems can be prevented.

In an embodiment of the present disclosure, the partition wall 680 may be spaced apart from the dome 650 by a second distance d2, which is substantially same as the first distance d1.

The partition wall 680 may include an organic insulating material, e.g., photo-acryl or benzocyclobutene (BCB), or an inorganic insulating material, e.g., silicon oxide or silicon nitride. For example, the partition wall 680 may be formed of the same material as the plurality of domes 650.

The first electrode 660a is separately formed in each pixel region P. The first electrode 660a may be an anode and may include a transparent conductive oxide (TCO) layer, which is formed of a conductive material, e.g., a transparent conductive oxide material, having a relatively high work function, and a reflective layer.

A shape of domes 650 is reflected onto the first electrode 660a so that the first electrode 660a has an uneven surface. For example, the first electrode 660a has a lens shape in correspondence to the dome 650 and a flat surface in correspondence to a space between adjacent domes 650.

The first electrode 660a is disposed on the partition wall 680 to have an uneven surface at the non-emission area NEA. For example, the first electrode 660a has a lens shape in correspondence to the partition wall 680 and a flat surface in correspondence to a space between the partition wall 680 and the dome 650.

A bank 654 is formed on the second planarization layer 643 at a boundary of the pixel region P. Namely, the bank 654 is positioned in the non-emission area NEA. The bank 654 covers an edge of the first electrode 660a and has an opening to expose a center of the first electrode 660a. Namely, the opening of the bank 654 exposes the first electrode 660a in an emission area EA. The bank 654 may be formed of an organic insulating material, e.g., photo-acryl, BCB or polyimide, and may have a single-layered structure or a multi-layered structure.

The bank 654 covers the partition wall 680. An end of the bank 654 may be positioned on a flat surface of the second planarization layer 643 between the partition wall 680 and the dome 650. In an embodiment of the present disclosure, the end of the bank 654 may be closer to the partition wall 680 than the dome 650.

A light emitting layer 660b covering the first electrode 660a and the bank 654 is provided. The light emitting layer 660b contacts the first electrode 660a in the opening of the bank 654. The light emitting layer 660b may be formed to contact an upper surface of the first electrode 660a and an upper surface and a side surface of the bank 654.

A shape of the domes 650 is reflected onto the light emitting layer 660b so that the light emitting layer 660b has an uneven surface. For example, the light emitting layer 660b has a lens shape in correspondence to the dome 650 and a flat surface in correspondence to a space between adjacent domes 650.

A second electrode 660c is formed over the substrate 602 where the light emitting layer 660b is formed. The second electrode 660c covers an entire surface of the display area DA. The second electrode 660c may be formed of at least one of ITO, IZO, Al, Ag, Cu, Pb, magnesium (Mg), Mo, Ti and their alloy and have a single-layered structure or a multi-layered structure. The second electrode 660c may have a thin profile (small thickness) to provide a light transmittance property (or a semi-transmittance property).

A shape of the domes 650 is reflected onto the second electrode 660c so that the second electrode 660c has an uneven surface. For example, the second electrode 660c has a lens shape in correspondence to the dome 650 and a flat surface in correspondence to a space between adjacent domes 650.

The first electrode 660a, the light emitting layer 660b and the second electrode 660c constitute a light emitting diode D. The organic light emitting diode D may emit the red, green and blue light in the red, green and blue pixel region, respectively.

In the light emitting display device 600, the light from the light emitting layer 660b passes through the second electrode 660c to display an image. Namely, the light emitting display device 600 of the present disclosure is a top-emission type display device.

In the light emitting diode display device 600 of the present disclosure, the domes 650 corresponding to the first electrode 660a are disposed on the second planarization layer 643 so that a viewing angle is enlarged.

The partition wall 680 is disposed in the non-emission area NEA, and the first electrode 660a covers the partition wall 680 to have a lens shape. Accordingly, a viewing angle can be controlled by the partition wall 680 and the first electrode 660a covering the partition wall 680, and the light toward adjacent pixel region can be blocked so that a color mixture problem can be prevented.

Moreover, since the second planarization layer 643 has a third thickness t3 at the emission area EA and a fourth thickness t4, which is larger than the third thickness t3, at the non-emission area NEA, the partition wall 680 is disposed to be higher than the dome 650. Accordingly, the light emitting diode display device 600 with the partition wall 680 and the dome 650 having substantially the same thickness provides an effect of a viewing angle control without an increase of a thickness of the device.

Furthermore, a distance between the dome 650 and the partition wall 680 is smaller than a distance between adjacent domes 650. As a result, the viewing angle can be controlled, and the brightness in a front view can be maximized.

Further, the partition wall 680 is thicker than the dome 650 so that a viewing angle can be efficiently controlled.

Further, the dome 650 in an edge of the emission area EA is thicker than the dome 650 in a center of the emission area EA. As a result, the viewing angle can be controlled, and the brightness in a front view can be maximized.

FIG. 8 is a schematic cross-sectional view illustrating a light emitting diode display device of a fifth embodiment of the disclosure. FIG. 8 is a schematic cross-sectional view taken along the line I-I' in FIG. 3.

For convenience of the explanation, the element between the substrate 702 and the second planarization layer 743, the elements over the light emitting diode D and the connection electrode 144 (of FIG. 2) are omitted.

As shown in FIG. 8, a light emitting diode display device 700 includes a second planarization layer 743 on the substrate 702, a plurality of domes 750 disposed on the second planarization layer 743 and corresponding to the emission area EA, a partition wall 780 disposed on the second planarization layer 743 and corresponding to the non-emission area NEA and a bank 754 covering the partition wall 780 and corresponding to the non-emission area NEA.

The second planarization layer 743 includes a groove in the emission area EA. The groove includes a first groove 745 positioned in a center of the emission area EA and a second groove 747 positioned in an edge of the emission area EA. Namely, the second groove 747 is positioned between the first groove 745 and the non-emission area NEA. The second groove 747 may be included in the second planarization layer 743 positioned between the dome 750 in an edge of the emission area EA and the partition wall 780. The first groove 745 may correspond to a space between adjacent domes 750.

With respect to the second groove 747 in the edge of the emission area EA, a height of the partition wall 780 is increased. Accordingly, the light emitting diode display device 700 with the partition wall 780 and the grooves 745 and 747 provides an effect of a viewing angle control without an increase of a thickness of the device.

The first groove 745 has a first depth h1, and the second groove 747 has a second depth h2. The first and second depths h1 and h2 may be substantially same.

In an embodiment of the present disclosure, the first depth h1 may be smaller than the second depth h2. When the first depth h1 is larger than the second depth h2, the light emitted in a center of the emission area EA may be trapped in the first groove 745 so that the brightness may be decreased. However, when the first depth h1 is smaller than the second depth h2, the trap of the light in the first groove 745 can be prevented. The light from an edge of the emission area EA toward a side direction can be efficiently blocked.

The domes 750 are disposed on the second planarization layer 743 and spaced apart from each other in the emission area EA. The dome 750 is positioned on a flat surface of the second planarization layer 743 between the grooves 745 and 747. The second planarization layer 743 may have a flat surface corresponding to a space between adjacent domes 750. The domes 750 may be spaced apart from each other by a first distance d1.

The domes 750 may include an organic insulating material, e.g., photo-acryl or benzocyclobutene (BCB), or an inorganic insulating material, e.g., silicon oxide or silicon nitride.

The partition wall 780 is disposed in the non-emission area NEA and spaced apart from the domes 750. The partition wall 780 has substantially the same shape as the dome 750. The partition wall 780 may have a lens shape or a dome shape.

Each dome 750 has a first thickness t1, and the partition wall 780 has a second thickness t2 being substantially same as the first thickness t1. In other words, each dome 750 has a first height from the substrate 702, and the partition wall 780 has a second height, which is substantially same as the first height, from the substrate 702.

In an embodiment of the present disclosure, the second thickness t2 of the partition wall 780 may be larger than the first thickness t1 of the dome 750.

In FIG. 8, the plurality of domes 750 have the same thickness. In an embodiment of the present disclosure, the dome 750 in a center of the emission area EA may have a thickness being smaller than the dome 750 in an edge of the emission area EA. For example, a thickness of the domes 750 may be gradually increased from a center of the emission area EA to an edge of the emission area EA.

In an embodiment of the present disclosure, the dome 750 includes a first dome and a second dome between the first dome and the partition wall 780, and a thickness of the second dome may be larger than that of the first dome. A thickness of the second dome may be smaller than that of the partition wall 780. In this case, a viewing angle in a center of the emission area EA can be maximized, and a viewing angle can be easily adjusted (controlled) by the domes 750 having different thicknesses.

When a distance d1 between adjacent domes 750 is smaller than a distance d2 between the dome 750 and the partition wall 780, the light may be trapped in adjacent domes 750 so that the emission efficiency may be decreased. When a distance d2 between the dome 750 and the partition wall 780 is greater than a distance d1 between adjacent domes 750, a viewing angle at an edge of the emission area EA may be too wide or the light leakage may occur at an edge of the emission area EA. However, in the light emitting diode display device 700, since the distance d2 between the dome 750 at an end of the emission area EA and the partition wall 780 is smaller than the distance d1 between adjacent domes 750, the above problems can be prevented.

In an embodiment of the present disclosure, the partition wall 780 may be spaced apart from the dome 750 by a second distance d2, which is substantially same as the first distance d1.

The partition wall 780 may include an organic insulating material, e.g., photo-acryl or benzocyclobutene (BCB), or an inorganic insulating material, e.g., silicon oxide or silicon nitride. For example, the partition wall 780 may be formed of the same material as the plurality of domes 750.

The first electrode 760a is separately formed in each pixel region P. The first electrode 760a may be an anode and may include a transparent conductive oxide (TCO) layer, which is formed of a conductive material, e.g., a transparent conductive oxide material, having a relatively high work function, and a reflective layer.

A shape of domes 750 is reflected onto the first electrode 760a so that the first electrode 760a has an uneven surface. For example, the first electrode 760a has a lens shape in correspondence to the dome 750 and a flat surface in correspondence to a space between adjacent domes 750.

The first electrode 760a is disposed on the partition wall 780 to have an uneven surface at the non-emission area NEA. For example, the first electrode 760a has a lens shape in correspondence to the partition wall 780 and a flat surface in correspondence to a space between the partition wall 780 and the dome 750.

As shown in FIG. 2, the connection electrode 144 may be disposed under a bank 745, and the first electrode 760a may be connected to the connection electrode 144 through a contact hole. Alternatively, the connection electrode 144 may be disposed to correspond to the first groove 745, and the first electrode 760a may be connected to the connection electrode 144 through a contact hole in the first groove 745.

A bank 754 is formed on the second planarization layer 743 at a boundary of the pixel region P. Namely, the bank 754 is positioned in the non-emission area NEA. The bank 754 covers an edge of the first electrode 760a and has an opening to expose a center of the first electrode 760a. Namely, the opening of the bank 754 exposes the first electrode 760a in an emission area EA. The bank 754 may be formed of an organic insulating material, e.g., photo-acryl, BCB or polyimide, and may have a single-layered structure or a multi-layered structure.

The bank 754 covers the partition wall 780. An end of the bank 754 may be positioned on a flat surface of the second planarization layer 743 between the partition wall 780 and the dome 750. In an embodiment of the present disclosure, the end of the bank 754 may be closer to the partition wall 780 than the dome 750.

A light emitting layer 760b covering the first electrode 760a and the bank 754 is provided. The light emitting layer 760b contacts the first electrode 760a in the opening of the bank 754. The light emitting layer 760b may be formed to contact an upper surface of the first electrode 760a and an upper surface and a side surface of the bank 754.

A shape of the domes 750 is reflected onto the light emitting layer 760b so that the light emitting layer 760b has an uneven surface. For example, the light emitting layer 760b has a lens shape in correspondence to the dome 750 and a flat surface in correspondence to a space between adjacent domes 750.

A second electrode 760c is formed over the substrate 702 where the light emitting layer 760b is formed. The second electrode 760c covers an entire surface of the display area DA. The second electrode 760c may be formed of at least one of ITO, IZO, Al, Ag, Cu, Pb, magnesium (Mg), Mo, Ti and their alloy and have a single-layered structure or a multi-layered structure. The second electrode 760c may have a thin profile (small thickness) to provide a light transmittance property (or a semi-transmittance property).

A shape of the domes 750 is reflected onto the second electrode 760c so that the second electrode 760c has an uneven surface. For example, the second electrode 760c has a lens shape in correspondence to the dome 750 and a flat surface in correspondence to a space between adjacent domes 750.

The first electrode 760a, the light emitting layer 760b and the second electrode 760c constitute a light emitting diode D. The organic light emitting diode D may emit the red, green and blue light in the red, green and blue pixel region, respectively.

In the light emitting display device 700, the light from the light emitting layer 760b passes through the second electrode 760c to display an image. Namely, the light emitting display device 700 of the present disclosure is a top-emission type display device.

In the light emitting diode display device 700 of the present disclosure, the domes 750 corresponding to the first electrode 760a are disposed on the second planarization layer 743 so that a viewing angle is enlarged.

The partition wall 780 is disposed in the non-emission area NEA, and the first electrode 760a covers the partition wall 780 to have a lens shape. Accordingly, a viewing angle can be controlled by the partition wall 780 and the first electrode 760a covering the partition wall 780, and the light toward adjacent pixel region can be blocked so that a color mixture problem can be prevented.

Moreover, since the second planarization layer 743 includes the grooves 745 and 747 in the emission area EA, a height of the partition wall 780 is increased with respect to the second groove 747 in an edge of the emission area EA. Accordingly, the light emitting diode display device 700 with the partition wall 780 and the grooves 745 and 747 provides an effect of a viewing angle control without an increase of a thickness of the device.

Furthermore, a distance between the dome 750 and the partition wall 780 is smaller than a distance between adjacent domes 750. As a result, the viewing angle can be controlled, and the brightness in a front view can be maximized.

Further, the partition wall 780 is thicker than the dome 750 so that a viewing angle can be efficiently controlled.

Further, the dome 750 in an edge of the emission area EA is thicker than the dome 750 in a center of the emission area EA. As a result, the viewing angle can be controlled, and the brightness in a front view can be maximized.

FIG. 9 is a schematic cross-sectional view illustrating a light emitting diode display device according to a sixth embodiment of the present disclosure. FIG. 9 is a schematic cross-sectional view taken along the line I-I' in FIG. 3.

For convenience of the explanation, the element between the substrate 802 and the second planarization layer 843, the elements over the light emitting diode D and the connection electrode 144 (of FIG. 2) are omitted.

As shown in FIG. 9, a light emitting diode display device 800 includes a second planarization layer 843 on the substrate 802, a plurality of domes 850 disposed on the second planarization layer 843 and corresponding to the emission area EA, a partition wall 880 disposed on the second planarization layer 843 and corresponding to the non-emission area NEA and a bank 854 covering the partition wall 880 and corresponding to the non-emission area NEA.

The light emitting diode display device 800 in FIG. 9 has a main difference in the second planarization layer 843 from the light emitting diode display device 700 in FIG. 8. Accordingly, the explanation of the domes 850, the partition wall 880, the bank 854 and a light emitting diode D including a first electrode 860a, a light emitting layer 860b and a second electrode 860c are omitted, and the explanation is focused on the second planarization layer 843.

The second planarization layer 843 has a flat surface in a center of the emission area EA and includes a groove 847 positioned at an edge of the emission area EA. Namely, the groove 847 is disposed to be closer to the non-emission area NEA.

With respect to the groove 847 in the edge of the emission area EA, a height of the partition wall 880 is increased. Accordingly, the light emitting diode display device 800 with the partition wall 880 and the groove 847 provides an effect of a viewing angle control without an increase of a thickness of the device.

In the light emitting diode display device 800 of the present disclosure, the domes 850 corresponding to the first electrode 860a are disposed on the second planarization layer 843 so that a viewing angle is enlarged.

The partition wall 880 is disposed in the non-emission area NEA, and the first electrode 860a covers the partition wall 880 to have a lens shape. Accordingly, a viewing angle can be controlled by the partition wall 880 and the first electrode 860a covering the partition wall 880, and the light toward adjacent pixel region can be blocked so that a color mixture problem can be prevented.

Moreover, since the second planarization layer 843 includes the groove 847 in the emission area EA, a height of the partition wall 880 is increased with respect to the groove 847 in an edge of the emission area EA. Accordingly, the light emitting diode display device 800 with the partition wall 880 and the groove 847 provides an effect of a viewing angle control without an increase of a thickness of the device.

Furthermore, a distance between the dome 850 and the partition wall 880 is smaller than a distance between adjacent domes 850. As a result, the viewing angle can be controlled, and the brightness in a front view can be maximized.

Further, the partition wall 880 is thicker than the dome 850 so that a viewing angle can be efficiently controlled.

Further, the dome 850 in an edge of the emission area EA is thicker than the dome 850 in a center of the emission area EA. As a result, the viewing angle can be controlled, and the brightness in a front view can be maximized.

It will be apparent to those skilled in the art that various modifications and variations can be made in the embodiments of the present disclosure without departing from the scope of the present disclosure. Thus, it is intended that the modifications and variations cover this disclosure provided they come within the scope of the appended claims and their equivalents.

## Claims

1. A light emitting diode display device, comprising:
a substrate (302) including a plurality of emission areas (EA) and a non-emission area (NEA) between the emission areas (EA);
a planarization layer (343) corresponding to the emission areas (EA) and the non-emission area (NEA) and disposed on the substrate (302);
a plurality of domes (350) corresponding to the emission areas (EA) and disposed on the planarization layer (343), the plurality of domes (350) are spaced apart from each other;
a partition wall (380) corresponding to the non-emission area (NEA) and disposed on the planarization layer (343), the partition wall (380) is spaced apart from the domes (350);
a first electrode (360a) covering the planarization layer (343) in the emission area (EA), the domes (350) and at least a portion of the partition wall (380); and
a bank (354) disposed in the non-emission area (NEA) and covering the first electrode (360a) and/or the partition wall (380).

2. The light emitting diode display device according to claim 1, wherein each of the domes (350) has a first thickness (t1), and the partition wall (380) has a second thickness (t2), wherein the second thickness (t2) is same as the first thickness (t1) or the second thickness (t2) is larger than the first thickness (t1).

3. The light emitting diode display device according to claim 1 or 2, wherein the domes (350) include a first dome and a second dome positioned between the first dome and the partition wall (380), wherein the first dome has a first thickness (t1), and the partition wall (380) has a second thickness (t2), and the second dome has a third thickness larger than the first thickness and smaller than the second thickness (t2).

4. The light emitting diode display device according to any one of the preceding claims, wherein the partition wall (580) has a reverse-tapered shape, preferably the first electrode (360a) exposes an upper surface of the partition wall (580).

5. The light emitting diode display device according to any one of the preceding claims, wherein the first electrode (360a) covers a side surface of the partition wall (380, 480, 580).

6. The light emitting diode display device according to any one of the preceding claims, wherein the planarization layer (643) has a third thickness (t3) in the emission area (EA) and a fourth thickness (t4) in the non-emission area (NEA), wherein the fourth thickness (t4) is larger than the third thickness (t3), preferably the dome (650) has a first thickness (t1), and the partition wall (680) has a second thickness (t2), and the second thickness (t2) is same as the first thickness (t1) or the second thickness (t2) is smaller than the first thickness (t1).

7. The light emitting diode display device according to any one of the preceding claims, wherein the planarization layer (743) includes at least one first groove (745) in the emission area (EA), and/or the planarization layer (743) positioned between the dome (750) at an edge of the emission area (EA) and the partition wall (880) includes a second groove (747).

8. The light emitting diode display device according to claim 7, wherein the first groove (745) has a first depth (h1), and the second groove (747) has a second depth (h2), preferably the second depth (h2) is smaller than the first depth (h1).

9. The light emitting diode display device according to any one of the preceding claims, wherein the planarization layer (343, 443, 543, 643, 743, 843) has a flat surface corresponding to a space between adjacent domes (350, 450, 450, 550, 650, 750, 850).

10. The light emitting diode display device according to any one of the preceding claims, wherein adjacent two of the domes (350, 450, 450, 550, 650, 750, 850) are spaced apart from each other by a first distance (d1), and the partition wall (350, 450, 450, 550, 650, 750, 850) is spaced apart from the dome (350, 450, 450, 550, 650, 750, 850) by a second distance (d2), and wherein the second distance (d2) is smaller than the first distance (d1).

11. The light emitting diode display device according to any one of the preceding claims, further comprising:
a light emitting layer (360b) on the first electrode (360a); and
a second electrode (360c) on the light emitting layer (360c).

12. The light emitting diode display device according to any one of the preceding claims, wherein the substrate (302) further includes a first pixel (P1), a second pixel (P2) and a third pixel (P3), and each of the first to third pixels (P1-P3) includes the emission area (EA).

13. The light emitting diode display device according to claim 12, wherein the first pixel (P1) extends along a first direction (X), the second pixel (P2) is spaced apart from the first pixel (P1) in a second direction (Y), and the third pixel (P3) is disposed at one side of the first and second pixels (P1, P2) in the first direction (X).

14. The light emitting diode display device according to claim 12 or 13, wherein the first pixel (P1) has a rectangular shape with a major axis in first direction (X), and the third pixel (P3) has a rectangular shape with a major axis in the second direction (Y) and the second pixel (P2) has a square shape, preferably in first direction (X), the first and second pixels (P1, P2) face each other and in second direction (Y), the second and third pixels (P2, P3) face each other.

15. The light emitting diode display device according to claim 12, 13 or 14, further comprising:
a thin film transistor (T1, T2) in each of the first to third pixels (P1-P3),
wherein a first contact hole (361a) for electrically connecting the first electrode (360a) in the first pixel (P1) to the thin film transistor (T2) in the first pixel (P1) is positioned at a side of the first pixel (P1) toward the second pixel (P2),
wherein a second contact hole (361b) for electrically connecting the first electrode (360a) in the second pixel (P2) to the thin film transistor (T2) in the second pixel (P2) is positioned at a side of the second pixel (P2) toward the first pixel (P1), and
wherein a third contact hole (361c) for electrically connecting the first electrode (360a) in the third pixel (P3) to the thin film transistor (T2) in the third pixel (P3) is positioned at a side of the third pixel (P3) toward the first and second pixels (P1, P2).
